# EUROPÄISCHE PATENTSCHRIFT

(11) **EP 0 318 998 B1**
(45) Veröffentlichungstag und Bekanntmachung des Hinweises auf die Patenterteilung: **06.10.1993**
(21) Anmeldenummer: 88120080.2
(22) Anmeldetag: 01.12.1988
(51) Int. Cl.: C23C 14/06, C23C 14/32

(54) **Verfahren zur Herstellung wärmestabiler Schichten mit hochharten und/oder reibarmen Eigenschaften**
Process for the production of thermally stable layers with a great hardness and/or low-friction properties
Procédé de production de couches thermiquement stables présentant une grande dureté et/ou des propriétés de faible friction

(30) Priorität: 04.12.1987 DE 3741127
(43) Veröffentlichungstag der Anmeldung: 07.06.1989
(73) Patentinhaber: Repenning, Detlev, Dr., D-21465 Reinbek (DE)
(72) Erfinder: Repenning, Detlev, Dr., D-21465 Reinbek (DE)
(74) Vertreter: Niedmers, Ole, Dipl.-Phys.

(56) Entgegenhaltungen:
- WO-A-87/02072
- JOURNAL OF VACUUM SCIENCE & TECHNOLOGY A, Band 4, Nr. 6, 2. Serie, November/Dezember 1986, Seiten 2892-2899, American Vacuum Society, Woodbury, NY, US; C. WEISSMANTEL et al.: "Structure property relationships of carbonaceous films grown under ion enhancement"
- H.Pulker et al.: "Verschleissschutzschichten unter Anwendung der CVD/PVD-Verfahren", Kontakt & Studium Band 188, Expert Verlag, Sindelfingen (1985), Seiten 179-181

## Beschreibung

Die Erfindung betrifft ein Verfahren zur Herstellung von Schichten mit hochharten und/oder reibarmen Eigenschaften, bei dem in einem Vakuum, in das ein reaktives Gas eingeführt wird, sich auf einem elektrischen Potential befindliches Targetmaterial in ein Targetplasma überführt wird, das auf ein Substrat, das auf einem höheren elektrischen Potential als das Targetmaterial liegt, zur Bildung der Schicht gelangt, daß das Targetmaterial aus Metall gebildet wird und das Metall mittels eines Lichtbogens zu einem Metallplasma verdampft wird, wobei das reaktive Gas mit dem Metallplasma zur Bildung der Schicht beiträgt.

Ein Verfahren dieser Art ist bekannt (WO-A-8 702 072). Das bekannte Verfahren basiert auf der Anwendung eines seit langem bekannten PVD-Verfahrens (Physical Vapour Deposition), das durch bestimmte Verfahrensschritte gegenüber den bis dahin bekannten PVD-Verfahren modifiziert ist. Dort wird eine Metallzerstäubungstechnik mittels eines Lichtbogens beschrieben, der die bis dahin übliche Metallzerstäubungstechnik ersetzt. Mit dem bekannten Verfahren werden Schichtungen erzeugt, die festkörperphysikalisch sogenannte 1-phasige Schichten darstellen, wobei es sich um interstitiell gelösten Kohlenstoff im Metall handelt, d.h. der Kohlenstoff bildet mit dem Metall eine feste Lösung. Interstitielle Lösungen bilden homogene, feste Mischungen, in denen zwei oder mehrere chemische Stoffe ein gemeinsames Kristallgitter bilden.

Die Herstellung derartiger Schichten, insbesondere kohlenstoffreicher Carbid-Composite-Verbindungen erfolgt bis heute unter Anwendung der bekannten PVD-Verfahren (Magnetronsputtern). Dabei wird in einem Hochvakuumrezipienten Metall mittels Argon-Ionenbeschuß zerstäubt. Durch Hinzufügen eines kohlenstoffhaltigen Gases, beispielsweise Azetylen, reagiert das Metall an der Oberfläche eines auf negativem Potential liegenden Substrats, das ein zu beschichtendes Werkstück sein kann, zu einem Metallcarbid oder bei entsprechend hohem Druck des Azetylens zu sogenanntem Metallkohlenstoff.

Um jedoch Schichten der eingangs genannten Art in unbegrenzter Zahl in gleichmäßiger Qualität reproduzieren zu können, d.h. mit Eigenschaften, die fortwährend bei allen zu beschichtenden Werkstücken oder dergl. gleich sind, ist es nötig, daß der Kohlenwasserstoff und das Metall im Plasma hochionisiert ist.

Der Nachteil des bekannten PVD-Verfahrens sowie des oben genannten bekannten PVD-Verfahrens liegt darin, daß bei der bekannten PVD-Metallzerstäubungstechnik der Ladungsanteil der zerstäubten Metallteilchen nur bei ca. 1 - 5% liegt. Ein anderer Nachteil des bekannten PVD-Verfahrens bei der Ausbildung derartiger Schichten liegt darin, daß die damit zu erreichenden Schichten ungleichmäßig in deren Bildung und Aufbau sind, wobei der sich aus dem vorerwähnten geringen Ladungsanteil ergebende Nachteil des bekannten Verfahrens sich auch in einer verhältnismäßig geringen Beschichtungsrate widerspiegelt, so daß der Aufbau mittels des bekannten Verfahrens eine verhältnismäßig lange Zeit braucht.

Schließlich hat sich auch gezeigt, daß das bekannte PVD-Verfahren zur Ausbildung der Schichten nur bedingt geeignet ist, wenn die Schichten neben den hochharten und/oder reibarmen Eigenschaften auch noch wärmestabil sein sollen. Für verschiedene Anwendungszwecke, beispielsweise in Lagern oder Ventilen, kommt es darauf an, daß die hochharten und/oder reibarmen Eigenschaften bei hohen Arbeits- bzw. Umgebungstemperaturen nicht verlorengehen.

Es ist Aufgabe der vorliegenden Erfindung, ein Verfahren zu schaffen, bei dem im Vergleich zu den bekannten Verfahren Schichten hergestellt werden können, die fortwährend gleiche Eigenschaften haben und die gegenüber den nach den bekannten Verfahren hergestellten Schichten bessere physikalische und chemische Eigenschaften haben, und diese bei hohen Arbeits- und Umgebungstemperaturen nicht verlieren, wobei das Verfahren gegenüber dem bekannten Verfahren mit einfacheren Mitteln ausführbar sein soll.

Gelöst wird die Aufgabe gemäß der Erfindung dadurch, daß das Metall eine Titanlegierung ist und die Überführung der Titanlegierung in das Plasma in der Gasphase ionisierten Kohlenstoffs, der infolge eines Glimmentladungsvorganges eines kohlenstoffhaltigen Gases entsteht, zur Bildung einer mikro- oder nanodispersen ternären Titanlegierungscarbid-, Titanlegierungs- und Kohlenstoffschicht mit wärmestabilen Eigenschaften (Schicht aus einem Gemisch von Titanlegierungscarbid, Titanlegierung und elementarem Kohlenstoff) erfolgt, wobei die Titanlegierung in der Gasphase bis in den Bereich von 90 % ionisiert wird, und der Kohlenstoff infolge eines Glimmentladungsvorganges an einer auf einem höheren Potential als das Targetmaterial befindlichen Elektrode der Elektrodenanordnung ionisiert wird.

Der Vorteil des erfindungsgemäßen Verfahrens besteht im wesentlichen darin, daß durch den hohen Ionisierungsanteil (bis zu 90 %) der im Lichtbogen verdampften Titanlegierung besonders günstige Voraussetzungen zum Wachstum von ternären Schichten geschaffen werden, die aus dem Carbid der Titanlegierung, der Titanlegierung und Kohlenstoff bestehen. Ein weiterer wesentlicher Vorteil der Erfindung liegt darin, daß durch das Verfahren ein dichtes feinkörniges Wachstum der Schicht erreichbar ist.

Der weitaus wichtigste Vorteil gegenüber den bzw. dem bekannten Verfahren liegt jedoch darin, daß durch den Aufbau der mit dem erfindungsgemäßen Verfahren hergestellten Schicht eine bisher vergeblich angestrebte Eigenschaft erreicht wird, daß nämlich die hergestellte Schicht neben der hochharten als auch gleichzeitig reibarmen Eigenschaft wärmestabil ist. Diese Eigenschaft wird mit dem erfindungsgemäßen Verfahren dadurch erreicht, daß in der Schicht neben der Titanlegierung und dem Carbid der Titanlegierung Kohlenstoff so eingefügt wird, daß in die harte Carbidmatrix dispers gelöster Kohlenstoff eingebaut wird.

Zwar ist aus der deutschen Patentanmeldung DE-A-37 12 205.3 ein Verfahren zur Herstellung von Schichten mit hochharten diamantähnlichen und/oder reibungsarmen Eigenschaften bekannt. Dieses dort beschriebene Verfahren verwendet jedoch als Targetmaterial Kohlenstoff, der zur Ausbildung der diamantähnlichen Schichten in Form festen Targetmaterials vorliegt.

Gemäß einer vorteilhaften Ausgestaltung der Erfindung wird die Titanlegierung aus Titan und Hafnium gebildet, gemäß einem anderen vorteilhaften Verfahren wird die Titanlegierung aus Titan und Zirkonium gebildet.

In der Titanlegierung kann der Titananteil in einem Bereich zwischen 5 - 90% liegen, wobei sich herausgestellt hat, daß eine Legierung mit einem Titananteil von 25% besonders vorteilhaft ist.

Zur Erzeugung des ionisierten Kohlenstoffs werden gemäß einer weiteren vorteilhaften Ausgestaltung der Erfindung Kohlenwasserstoffe wie Methan, Propan, Azetylen oder Butadien verwendet. Grundsätzlich eignen sich dazu auch andere, hier nicht gesondert aufgeführte, Kohlenwasserstoffe.

Vorzugsweise wird in das Vakuum bzw. zum Kohlenstoff ein nichtreaktives Gas gegeben. Dieses Gas kann vorteilhafterweise Argon sein.

Gemäß einer weiteren vorteilhaften Ausgestaltung der Erfindung weist das Kohlenwasserstoffgas bei der Ausführung des Verfahrens einen Druck von 10⁻³ bis 5 x 10⁻² mbar auf. Es sei darauf verwiesen, daß der Druck des Kohlenwasserstoffgases für bestimmte auszubildende Schichten mit bestimmten zu erwartenden Eigenschaften auf bestimmte Werte optimiert werden kann. Schließlich ist gemäß einer weiteren vorteilhaften Ausgestaltung des Verfahrens durch vorbestimmte Variation der Substratspannung der Kohlenstoffgehalt der Schicht einstellbar.

Vorzugsweise liegt die Substratspannung dabei in einem Bereich von 50 bis 300V.

Vorteilhafterweise wird das Verfahren bei einer Abscheidetemperatur von 200 bis 500°C durchgeführt.

Um die erfindungsgemäß sich auf dem Substrat ausbildenden Schichten an die physikalischen Eigenschaften des Grundwerkstoffs des Substrats anpassen zu können, kann es wegen extrem stark auseinanderliegender Ausdehnungskoeffizienten, Elastizitätsmodule und der Härte zwischen Substratwerkstoff und Schicht sinnvoll sein, vor dem Aufbringen der Schicht auf dem Substrat vorteilhafterweise eine Gradientschicht zunächst aufzubringen. Als Werkstoff für die Ausbildung einer Gradientschicht eignet sich beispielsweise Chrom, der auch haftvermittelnde Eigenschaften aufweist.

Schließlich sei hervorgehoben, daß gemäß dem hier vorgeschlagenen Verfahren auch Mehrfachschichten hergestellt werden können, wobei die einzelnen Schichten neben der erfindungsgemäßen ternären Schicht aus der Titanlegierung, dem Carbid der Titanlegierung und dem darin dispers gelöstem Kohlenstoff auch aus Schichten bestehen können, bei denen bei grundsätzlich gleichem ternären Aufbau die Legierungskomponente neben dem Titan in der einen Schicht aus Hafnium und in der anderen Schicht aus Zirkonium bestehen kann. Es ist darüber hinaus auch denkbär, daß mehrere Schichten aus der Titanlegierung, dem Carbid der Titanlegierung und darin dispers gelöstem Kohlenstoff übereinander aufgebaut werden können, wobei die einzelnen Schichten sich dadurch unterscheiden, daß das Verhältnis zwischen der Titanlegierung, dem Carbid der Titanlegierung und darin dispers gelöstem Kohlenstoff von Schicht zu Schicht unterschiedlich ist, wobei zusätzlich auch, wie oben schon dargestellt, der Titananteil in der Legierung variieren kann.

Die Erfindung wird nun unter Bezugnahme auf die einzige schematische Zeichnung, die eine Wärme- Härtekurve darstellt, in der der Härteverlauf der erfindungsgemäßen Schicht und einer Titankohlenstoffschicht in Abhängigkeit der Wärme dargestellt wird, beschrieben.

Das Verfahren kann grundsätzlich in einem gewöhnlichen Rezipienten durchgeführt werden, in dem über eine Pumpeneinrichtung ein Vakuum erzeugt wird. Über einen Gaseinlaß kann ein beliebiges Kohlenwasserstoffgas, beispielsweise Methan, Propan, Azetylen oder Butadien eingelassen werden. Das Target aus der Titanlegierung ist mit einer geeigneten Spannungsquelle verbunden. Ebenso ist eine Substratelektrode, die beispielsweise das zu beschichtende Werkstück bildet, mit einer Spannungsquelle verbunden. Das elektrische Potential des Substrats (zu beschichtendes Werkstück wie beispielsweise Druckgußwerkzeug, Warmarbeitsstähle) ist negativer als das Potential des Targetmaterials. Von einer Lichtbogenquelle wird eine Lichtbogen auf das Targetmaterial gegeben. Infolge der Ausbildung des Lichtbogens wird die Titanlegierung, die das Target bildet, "verdampft", so daß die Titanlegierung als Titanlegierungsplasma in die Gasphase überführt wird. Die Folge ist, daß die "verdampfte" Titanlegierung dann zu wenigstens 90% in der Gasphase elektrisch geladen, d.h. ionisiert ist.

Die durch den Lichtbogen erzeugten Titanlegierungsionen des Titanlegierungsplasmas driften durch den Glimmentladungsbereich zum Substrat und werden im Kathodenfallraum beschleunigt. Durch Kollosionsprozesse mit nichtionisierten und ionisiertem Kohlenstoff oder Kohlenwasserstoffteilchen werden diese energetisch hoch angeregt und bilden günstige Voraussetzungen zur Ausbildung hochharter und warmharter kohlenstoffhaltiger Schichten.

Die durch den Lichtbogen "verdampften" Titanlegierungsionen driften in Richtung Substrat (Werkstück) und reagieren an der Oberfläche mit dem Kohlenstoff des Kohlenwasserstoffs zu mikrodispersen 2-Phasen-Schichten die aus Carbiden und elementarem Kohlenstoff (mikrodisperses Gemisch) bestehen. Die entstehenden Schichten sind sehr hart, reibarm und wärmestabil.

Es sei hervorgehoben, daß der Prozeß gemäß diesem Verfahren in einem Hochvakuum-Rezepienten vorteilhafterweise in einem Druckbereich des Kohlenwasserstoffgases zwischen 10⁻³ bis 5 x 10⁻² mbar abläuft. Das Kohlenwasserstoffgas kann dabei durch nichtreaktive Gase, beispielsweise durch Argon, verdünnt sein.

Gemäß dem Verfahren sind Schichten aufbaubar, die infolge der Zu- bzw. Abnahme der steuerbaren Lichtbogenintensität unterschiedliche Eigenschaften haben. So können beispielsweise harte Titanlegierungscarbidschichten bis hin zu reibarmen Titanlegierungskohlenstoffschichten mit beispielsweise einem Titanlegierungsgehalt von nur noch 5% erzeugt werden, d.h. Schichten, die zwischen sehr reibarmen und sehr harten Eigenschaften liegen. Allen diesen Schichten ist aber gemeinsam, daß sie auch bei sehr hohen Arbeits- bzw. Umgebungstemperaturen stabil sind. Titanlegierungen sind beispielsweise Titanzirkonium und Titanhafnium.

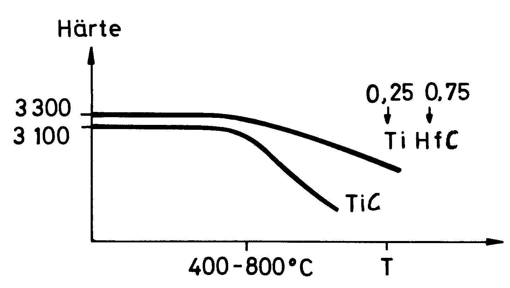

Dieses wärmestabile Verhalten ergibt sich auch unmittelbar aus der dargestellten einzigen Figur, aus der ersichtlich ist, daß bei einer Umgebungs- bzw. Arbeitstemperatur von 400 bis 500°C Titankohlenstoff bzw. Titancarbidschichten signifikant in ihrer Härte zurückgehen, während bei dieser Temperatur die Titanlegierungscarbidschichten bzw. Titanlegierungskohlenstoffschichten sich nur geringfügig in ihrer Härte vermindern. Es sei noch darauf verwiesen, daß trotz der verschiedenen Möglichkeiten der Ausbildung der Schicht aus der harten Titanlegierungscarbidmatrix und dem darin gelösten Kohlenstoff diese immer sowohl gute harte als auch gute reibarme Eigenschaften aufweist, so daß die vorangehend erwähnte extreme Eigenschaft (sehr reibarm, sehr hart) immer nur als besonders auffällig in Erscheinung tretende Eigenschaft anzusehen ist, wobei die jeweils andere Eigenschaft fortwährend gleichzeitig vorhanden ist, gegenüber der jeweils anderen als signifikant in Erscheinung tretenden Eigenschaft jedoch etwas zurücksteht. Sinngemäß das gleiche gilt für die Legierungskomponenten, die zum Titan hinzutreten, beispielsweise Zirkonium oder Hafnium.

Die Verwendung von Hafnium zur Bildung einer Titanhafniumlegierung wird in der Regel immer dann angestrebt, wenn extreme Warm- und Härteeigenschaften der Legierung erforderlich sind. Die Verwendung von Zirkonium zur Bildung einer Titanzirkoniumlegierung wird hingegen in der Regel immer dann angestrebt, wenn ein besonders gutes Korrosionsverhalten der erfindungsgemäß ausgebildeten Schicht erreicht werden soll.

Durch vorbestimmte Variation der Substratspannung ist weiterhin der Kohlenstoffgehalt in der Schicht einstellbar (Substratspannungsvariation 50 bis 300V), der beispielsweise bei einer Spannung von -50V relativ zu den Wänden des Rezipienten deutlich erhöht werden kann.

Abschließend ist zu sagen, daß mit den gemäß der Erfindung hergestellten Schichten Härten von größer als 3000 HV erreicht werden können, wobei oberhalb von 500°C Umgebungs- bzw. Arbeitstemperatur die Härte der Schicht sich nur geringfügig vermindert.

## Patentansprüche

1. Verfahren zur Herstellung von Schichten mit hochharten und/oder reibarmen Eigenschaften, bei dem in einem Vakuum, in das ein reaktives Gas eingeführt wird, sich auf einem elektrischen Potential befindendes Targetmaterial in ein Targetplasma überführt wird, das auf ein Substrat, das auf einem höheren elektrischen Potential als das Targetmaterial liegt, zur Bildung der Schicht gelangt, daß das Targetmaterial aus Metall gebildet wird und das Metall mittels eines Lichtbogens zu einem Metallplasma verdampft wird, wobei das reaktive Gas mit dem Metallplasma zur Bildung der Schicht beiträgt, dadurch gekennzeichnet, daß das Metall eine Titanlegierung ist und die Überführung der Titanlegierung in das Plasma in der Gasphase ionisierten Kohlenstoffs, der infolge eines Glimmentladungsvorganges eines kohlenstoffhaltigen Gases entsteht, zur Bildung einer mikro- oder nanodispersen ternären Titanlegierungscarbid-, Titanlegierungsund Kohlenstoffschicht mit wärmestabilenden Eigenschaften (Schicht aus einem Gemisch von Titanlegierungscarbid, Titanlegierung und elementarem Kohlenstoff) erfolgt, wobei die Titanlegierung in der Gasphase bis in den Bereich von 90 % ionisiert wird, und der Kohlenstoff infolge eines Glimmentladungsvorganges an einer auf einem höheren Potential als das Targetmaterial befindlichen Elektrode der Elektrodenanordnung ionisiert wird.

2. Verfahren nach Anspruch 1, dadurch gekennzeichnet, daß die Titanlegierung aus einer metallischen Mischphase aus Titan und Hafnium gebildet wird.

3. Verfahren nach Anspruch 1, dadurch gekennzeichnet, daß die Titanlegierung aus einer metallischen Mischphase aus Titan und Zirkonium gebildet wird.

4. Verfahren nach einem oder mehreren der Ansprüche 1 bis 3, dadurch gekennzeichnet, daß bei der Titanlegierung der Titananteil zwischen 5% bis 90% liegt.

5. Verfahren nach einem oder mehreren der Ansprüche 1 bis 4, dadurch gekennzeichnet, daß zur Erzeugung des ionisierten Kohlenstoffs Kohlenwasserstoffe wie Methan, Azetylen oder Butadien verwendet wird.

6. Verfahren nach einem oder mehreren der Ansprüche 1 bis 5, dadurch gekennzeichnet, daß das Kohlenwasserstoffgas bei der Ausführung des Verfahrens einen Druck 10⁻³ bis 5 x 10⁻³ mbar aufweist.

7. Verfahren nach einem oder mehreren der Ansprüche 1 bis 6, dadurch gekennzeichnet, daß in das Vakuum ein nicht reaktives Gas gegeben wird.

8. Verfahren nach Anspruch 7, dadurch gekennzeichnet, daß das nichtreaktive Gas ein Edelgas ist.

9. Verfahren nach Anspruch 8, dadurch gekennzeichnet, daß das Edelgas Argon ist.

10. Verfahren nach einem oder mehreren der Ansprüche 1 bis 9, dadurch gekennzeichnet, daß durch vorbestimmte Variation der Substratspannung der Kohlenstoffgehalt in der Schicht einstellbar ist.

11. Verfahren nach Anspruch 10, dadurch gekennzeichnet, daß die Substratspannung in einem Bereich von 50V bis 300V liegt.

12. Verfahren nach einem oder mehreren der Ansprüche 1 bis 11, dadurch gekennzeichnet, daß dieses bei einer Abscheidetemperatur von 200 - 500°C durchgeführt wird.

13. Verfahren nach einem oder mehreren der Ansprüche 1 bis 12, dadurch gekennzeichnet, daß vor Aufbringen der Schicht auf dem Substrat eine Gradientschicht auf diesem aufgebracht wird.

## Claims

1. A method of producing layers having high hardness and/or low friction properties in which in a vacuum into which a reactive gas is introduced, target material which is at an electrical potential is converted to a target plasma which is applied to a substrate which is at a higher electrical potential than the target material, in order to form the layer, the target material consisting of metal while the metal is vaporised by an arc to produce a metal plasma and contributing jointly with the reactive gas to the formation of the layer, characterised in that the metal is a titanium alloy and in that the conversion of the titanium alloy to the plasma takes place in the gaseous phase of ionised carbon which is created due to a glow discharge process within a carbonaceous gas, for forming a micro or nanodisperse ternary titanium alloy carbide, titanium alloy and carbon layer having heat stable properties (layer of a mixture of titanium alloy carbide, titanium alloy and an elementary carbon), the titanium alloy being ionised in the gaseous phase into the range of 90% and the carbon being ionised as the result of a glow discharge process on an electrode of the electrode arrangement which is at a higher potential than the target material.

2. A method according to claim 1, characterised in that the titanium alloy is formed form a mixed metallic phase consisting of titanium and hafnium.

3. A method according to claim 1, characterised in that the titanium alloy is formed from a mixed metallic phase consisting of titanium and zirconium.

4. A method according to one or more of claims 1 to 3, characterised in that the titanium proportion in the titanium alloy is between 5% and 90%.

5. A method according to one or more of claims 1 to 4, characterised in that hydrocarbons such as methane, acetylene or butadiene are used to produce the ionised carbon.

6. A method according to one or more of claims 1 to 5, characterised in that the hydrocarbon gas is at a pressure of 10⁻³ to 5 x 10⁻² mbar while the method is being performed.

7. A method according to one or more of claims 1 to 6, characterised in that a non-reactive gas is added to the vacuum.

8. A method according to claim 7, characterised in that the non-reactive gas is an inert gas.

9. A method according to claim 8, characterised in that the inert gas is argon.

10. A method according to one or more of claims 1 to 9, characterised in that the carbon content in the layer is adjustable by predetermined fluctuation of the substrate voltage.

11. A method according to claim 10, characterised in that the substrate voltage is within a range from 50 volts to 300 volts.

12. A method according to one or more of claims 1 to 11, characterised in that it is carried out at a deposition temperature of 200 to 500°C.

13. A method according to one or more of claims 1 to 12, characterised in that prior to the layer being applied to the substrate, a gradient layer is applied to this latter.

## Revendications

1. Procédé pour fabriquer des couches possédant des caractéristiques de grande dureté/ou de faible coefficient de frottement, selon lequel dans un espace vide, dans lequel est introduit un gaz réactif, un matériau cible placé à un potentiel électrique est converti en un plasma du matériau cible qui atteint un substrat, qui est placé à un potentiel électrique supérieur à celui du matériau cible, pour la formation de la couche, selon lequel le matériau cible est formé d'un métal, et le métal est vaporisé au moyen d'un arc électrique pour former un plasma du métal, le gaz réactif contribuant avec le plasma du métal à former la couche, caractérisé en ce que le métal est un alliage de titane et la conversion de l'alliage de titane en le plasma s'effectue dans la phase gazeuse de carbone ionisé, qui apparaît sous l'effet d'un processus de décharge à effluves dans un gaz contenant du carbone pour la formation d'une couche ternaire de carbure de l'alliage de titane et de carbone, dispersée à une taille de l'ordre du micron ou du nanomètre et possédant des caractéristiques de stabilité à la chaleur (couche formée d'un mélange d'un carbure d'alliage de titane, d'un alliage de titane et de carbone élémentaire), l'alliage de titane étant ionisé dans la phase gazeuse jusqu'à un pourcentage de 90%, et le carbone étant ionisé, en raison d'un processus de décharge à effluves, sur une électrode du dispositif d'électrodes, placée à un potentiel supérieur à celui du matériau cible.

2. Procédé selon la revendication 1, caractérisé en ce que l'alliage de titane est formé par une phase métallique mixte formée de titane et de hafnium.

3. Procédé selon la revendication 1, caractérisé en ce que l'alliage de titane est formé par une phase mixte métallique de titane et de zirconium.

4. Procédé selon l'une ou plusieurs des revendications 1 à 3, caractérisé en ce que dans le cas de l'alliage de titane, le pourcentage de titane est compris entre 5% et 90%.

5. Procédé selon l'une ou plusieurs des revendications 1 à 4, caractérisé en ce que pour la production du carbone ionisé, on utilise des carbures d'hydrogène tels que le méthane, l'acétylène ou le butadiène.

6. Procédé selon l'une ou plusieurs des revendications 1 à 5, caractérisé en ce que le gaz d'hydrocarbure possède, dans la forme de réalisation du procédé, une pression comprise entre 10⁻³ et 5 x 10⁻² m/bars.

7. Procédé selon l'une ou plusieurs des revendications 1 à 6, caractérisé en ce qu'on introduit un gaz non réactif dans l'espace vide.

8. Procédé selon la revendication 7, caractérisé en ce que le gaz non réactif est un gaz rare.

9. Procédé selon la revendication 8, caractérisé en ce que le gaz rare est de l'argon.

10. Procédé selon l'une ou plusieurs des revendications 1 à 9, caractérisé en ce que la teneur en carbone dans la couche est réglable grâce à une modification prédéterminée de la tension du substrat.

11. Procédé selon la revendication 10, caractérisé en ce que la tension du substrat se situe dans une gamme comprise entre 50 V et 300 V.

12. Procédé selon l'une ou plusieurs des revendications 1 à 11, caractérisé en ce que ce procédé est mis en oeuvre à une température de dépôt de 200-500°C.

13. Procédé selon l'une ou plusieurs des revendications précédentes, caractérisé en ce qu'avant le dépôt de la couche sur le substrat, on dépose une couche à gradient sur le substrat.
